(19)

(11) **EP 3 211 328 B1**

(12) **EUROPÄISCHE PATENTSCHRIFT**

(45) Veröffentlichungstag und Bekanntmachung des Hinweises auf die Patenterteilung:
**26.08.2020 Patentblatt 2020/35**

(51) Int Cl.:
***F24C 15/20*** *(2006.01)* ***H03K 17/955*** *(2006.01)*

(21) Anmeldenummer: **17153324.3**

(22) Anmeldetag: **26.01.2017**

(54) **DUNSTABZUGSHAUBE MIT NÄHERUNGSSCHALTER UND VERFAHREN ZUR STEUERUNG EINER DUNSTABZUGSHAUBE**

EXTRACTOR HOOD WITH PROXIMITY SWITCH AND METHOD FOR CONTROLLING A VAPOUR EXTRACTOR

HOTTE ASPIRANTE COMPRENANT UN CAPTEUR DE PROXIMITÉ ET ET SON PROCÉDÉ DE COMMANDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.02.2016 DE 102016202786**

(43) Veröffentlichungstag der Anmeldung:
**30.08.2017 Patentblatt 2017/35**

(73) Patentinhaber: **BSH Hausgeräte GmbH**
**81739 München (DE)**

(72) Erfinder:
- **Schrumpf, Stefan**
  **75015 Bretten-Gölshausen (DE)**
- **Wössner, Markus**
  **74374 Zaberfeld (DE)**

(56) Entgegenhaltungen:
**EP-A1- 2 261 568** **EP-A2- 2 224 174**
**EP-A2- 2 275 907** **US-A1- 2013 241 630**
**US-B1- 8 040 142**

EP 3 211 328 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die Erfindung betrifft eine Dunstabzugshaube mit einem Näherungsschalter zur Steuerung einer Funktion der Dunstabzugshaube sowie ein Verfahren zur Steuerung einer Dunstabzugshaube.

Dunstabzugshauben werden im Bereich einer Kochstelle angeordnet, um Dünste und Wrasen aus dem Bereich der Kochstelle abzusaugen. Üblicherweise wird die Dunstabzugshaube über der Kochstelle angebracht und umfasst ein elektrische angetriebenes Gebläse zum Absaugen von Luft sowie optional eine elektrische Beleuchtung der Kochstelle.

Zur Steuerung von Funktionen der Dunstabzugshaube, insbesondere zum Betreiben des Gebläses in unterschiedlichen Leistungsstufen und/oder zur Steuerung der Beleuchtung ist eine Steuereinrichtung vorgesehen, die beispielsweise mittels eines kapazitiven Näherungsschalters, der auch Sensorschalter genannt wird, bedient werden kann. Der Näherungsschalter umfasst eine Sensorelektrode, deren Kapazität bezüglich dem Erde-Potential bestimmt werden kann. Nähert ein Benutzer beispielsweise einen Finger an die Elektrode an, so verändert sich die Kapazität und eine zugeordnete Funktion kann ausgelöst werden.

Die Dunstabzugshaube umfasst eine Abdeckung, auf deren Innenseite die beschriebene Sensorelektrode angeordnet ist. Die Abdeckung ist üblicherweise aus Glas oder Kunststoff herstellbar und kann eine Dicke von mehreren Millimetern annehmen. Um den kapazitiven Näherungsschalter zu betätigen, kann der Benutzer einen Finger auf der Außenseite der Abdeckung in den Bereich der Elektrode halten.

EP 2 261 568 A1 betrifft ein elektromechanisches Küchengerät, das wenigstens eine mittels eines berührungsempfindlichen Steuergeräts steuerbare Funktion bereitstellt.

US 2013 /0241630A1 schlägt eine variable Spannungsversorgung eines zweidimensionalen kapazitiven Touchpads vor. In einer Variante wird die Spannung mittels einer Ladungspumpe erzeugt.

EP 2 224 174 A2 beschreibt eine Dunstabzugshaube, die eine Bedieneinrichtung aufweist. Die Bedieneinrichtung ist als separate Baueinheit in ein Gehäuse der Dunstabzugshaube eingesetzt. Die Bedieneinrichtung weist ein Bedienfeld auf mit mehreren Berührungsschaltern daran, die entlang einer Linie angeordnet sind und unter dem Bedienfeld angeordnete Sensorelemente aufweist zur Erkennung eines aufgelegten oder darüber gestrichenen Fingers.

Je dicker die Abdeckung ist, desto schwächer ist die Beeinflussung der Kapazität durch den Finger des Benutzers. Der Erfindung liegt die Aufgabe zugrunde, eine Technik anzugeben, die den zuverlässigen Einsatz eines kapazitiven Näherungsschalters an einer Dunstabzugshaube auch bei einer dickeren Abdeckung zulässt. Die Erfindung löst diese Aufgabe mittels der Gegenstände der unabhängigen Ansprüche. Unteransprüche geben bevorzugte Ausführungsformen an.

Der Erfindung liegt die Erkenntnis zugrunde, dass die Kapazität, die sich an der Elektrode einstellt, verbessert bestimmt werden kann, wenn die Elektrode auf eine erhöhte Spannung aufgeladen wird.

Gemäß einem ersten Aspekt wird die Aufgabe gelöst durch eine Dunstabzugshaube mit einem kapazitiven Näherungsschalter zur Steuerung einer elektrischen Funktion der Dunstabzugshaube. Der Näherungsschalter ist dazu eingerichtet, eine Änderung einer elektrischen Kapazität an einer Elektrode zu bestimmen und die Elektrode ist mittels einer nichtleitenden Abdeckung gegenüber einem Benutzer abgedeckt, wobei eine Spannungsanhebung vorgesehen ist, um die Elektrode auf eine höhere Spannung als eine Versorgungsspannung des kapazitiven Näherungsschalters aufzuladen, wobei die die Spannungsanhebung eine Ladungspumpe umfasst. Die Dunstabzugshaube ist dadurch gekennzeichnet, dass die Dunstabzugshaube einen als Kippschwinger ausgeführten Oszillator zur Bereitstellung einer Wechselspannung für die Spannungsanhebung umfasst und der Kippschwinger ein erstes invertierendes Gatter und die Ladungspumpe ein zweites invertierendes Gatter umfasst und beide Gatter in einem gemeinsamen elektronischen Bauteil integriert sind.

Eine Steuereinrichtung für die Dunstabzugshaube arbeitet üblicherweise mit einer Versorgungsspannung, die allgemein mittels eines Netzteils aus einer Netzspannung (230 V in Europa) bereitgestellt wird. Die Versorgungsspannung liegt im Bereich von wenigen Volt, beispielsweise zwischen ca. 5 bis ca. 20 V. Wird die Elektrode auf eine höhere Spannung als die Versorgungsspannung aufgeladen, beispielsweise ca. 30 bis 60 V, so kann eine Kapazitätsänderung, die insbesondere durch das Bewegen eines Fingers eines Benutzers in den Bereich der Elektrode hervorgerufen sein kann, zu einer größeren Kapazitätsänderung führen, die auch leichter oder sicherer bestimmt werden kann. Vorteilhafterweise können dadurch eine Schaltsicherheit oder eine Bedienbarkeit der Dunstabzugshaube verbessert sein. Insbesondere können die Handlungs- oder Arbeitsbedingungen des Benutzers durch die verbesserte Bedienbarkeit der Dunstabzugshaube verbessert sein.

Erfindungsgemäß umfasst die Spannungsanhebung eine Ladungspumpe. Die Versorgungsspannung umfasst üblicherweise eine Gleichspannung, die in einer anderen Ausführungsform auch mittels eines Gleichspannungswandlers, insbesondere eines Hochsetzstellers, auf eine höhere Spannung angehoben werden kann. Die Ladungspumpe hat jedoch den Vorteil, statt einer Spule nur einen Kondensator zu erfordern, wodurch die Ladungspumpe vergleichsweise kostengünstig aufgebaut werden kann. Die Aufladung der Elektrode erfordert üblicherweise nur einen geringen Strom, sodass schwach dimensionierte und somit kostengünstige Bauelemente, insbesondere Kondensatoren, verwendet werden können.

Vorzugsweise umfasst die Ladungspumpe mehrere kaskadierte, also hintereinandergeschaltete Stufen. Eine Stufe der Ladungspumpe kann ihre Eingangsspannung ungefähr verdoppeln. Durch das Kaskadieren mehrerer Stufen kann beispielsweise auch eine Verdreifachung, Vervierfachung oder weitere Vervielfachung bewirkt werden. Die einzelnen Stufen können in einander entsprechender Weise aufgebaut sein, wodurch die Spannungsanhebung leicht realisiert werden kann. In einer Ausführungsform wird die Versorgungsspannung mit einem Faktor multipliziert, die der Anzahl der Stufen entspricht. Allerdings kann die Ausgangsspannung um die Summe der Leerlaufspannungen von Dioden verringert sein, die in jeder Stufe vorgesehen sind.

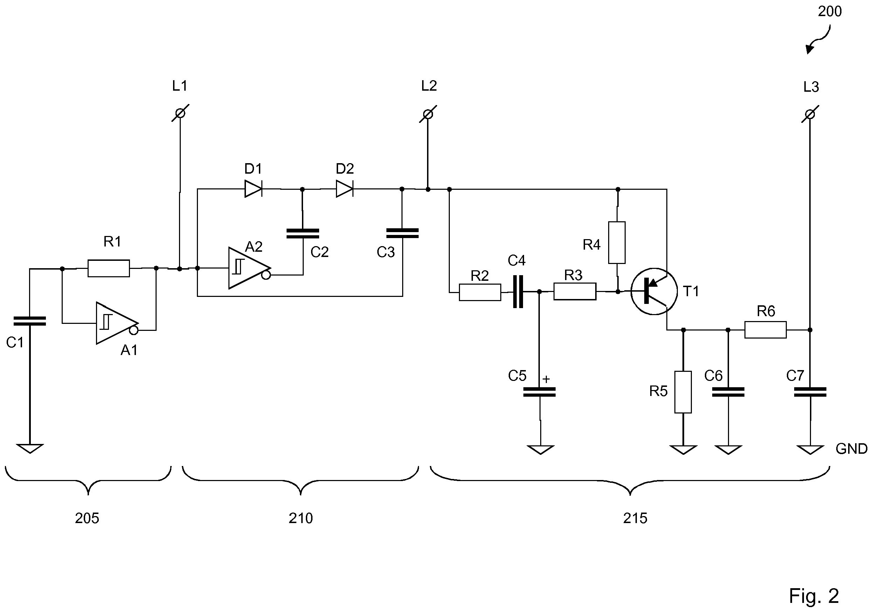

Allgemein ist bevorzugt, dass die Versorgungsspannung um wenigstens 150 % angehoben wird. Weiter ist bevorzugt, dass die Anhebung 200 % oder mehr beträgt. In einer besonders bevorzugten Ausführungsform der Spannungsanhebung, die unten mit Bezug auf Figur 2 noch genauer beschrieben wird, wird eine Verdopplung der Versorgungsspannung - abzüglich der Leerlaufspannungen zweier Dioden - bewirkt.

Erfindungsgemäß umfasst die Dunstabzugshaube einen Oszillator. Der Oszillator ist erfindungsgemäß als Kippschwinger ausgeführt und dient zur Bereitstellung einer Wechselspannung für die Spannungsanhebung. Der Oszillator wird vorzugsweise auf der Basis der Versorgungsspannung betrieben. Der Kippschwinger kann einfach und kostengünstig aufgebaut sein. Die bereitgestellte Wechselspannung muss nicht besonders frequenzstabil sein, sodass der Kippschwinger ohne Bedenken werden kann.

Erfindungsgemäß umfasst der Kippschwinger ein erstes invertierendes Gatter und die Ladungspumpe umfasst ein zweites invertierendes Gatter. Dabei sind beide Gatter vorteilhafterweise in einem gemeinsamen elektronischen Bauteil integriert. Das elektronische Bauteil kann insbesondere eine Standard-CMOS-Schaltung umfassen. Beispielsweise sind in der integrierten Schaltung CD4093 vier invertierende Gatter mit Schmitt-Trigger enthalten, sodass beispielsweise ein Oszillator und drei Stufen einer Ladungspumpe kostengünstig aufgebaut werden können.

In einer weiteren Ausführungsform ist ein Mikrocontroller vorgesehen, der dazu eingerichtet ist, die elektrische Funktion der Dunstabzugshaube zu steuern. In einer Variante realisiert der Mikrocontroller einen Oszillator zur Bereitstellung einer Wechselspannung für die Spannungsanhebung. Beispielsweise kann der Mikrocontroller einen programmierbaren Zähler umfassen, der eine vorbestimmte Taktfrequenz passend herunterteilt und nach außen zugänglich macht. In einer anderen Ausführungsform kann die Wechselspannung auch mittels eines Programms generiert werden, das auf dem Mikrocontroller abläuft und die Invertierung eines Ausgangssignals in vorbestimmten Zeitabständen realisiert.

Der Mikrocontroller kann zusätzlich oder alternativ auch dazu eingerichtet sein, eine Spannung an der Elektrode zu bestimmen und mit einer zuvor bestimmten Spannung zu vergleichen. Anders ausgedrückt kann der Mikrocontroller die Spannung an der Elektrode überwachen und eine Veränderung der Kapazität auf der Basis einer Veränderung der Spannung bestimmen. Überschreitet die Änderung der Kapazität einen bestimmten Wert oder überschreitet die Änderungsgeschwindigkeit der Kapazität einen bestimmten Wert, so kann das Aktivieren oder Deaktivieren des Näherungsschalters durch einen Benutzer bestimmt werden. In der Folge kann eine dem kapazitiven Näherungsschalter zugeordnete Funktion der Dunstabzugshaube aktiviert oder deaktiviert werden.

Gemäß einem weiteren Aspekt wird die Aufgabe gelöst durch ein Verfahren zur Steuerung einer Dunstabzugshaube, das die Schritte des Anhebens einer Versorgungsspannung auf eine höhere Spannung, des Aufladens einer Kapazität an einer Elektrode mittels der angehobenen Spannung, des Bestimmens einer durch einen Benutzer der Dunstabzugshaube bewirkten Veränderung der Kapazität, und das Steuern einer elektrischen Funktion der Dunstabzugshaube in Abhängigkeit der bestimmten Veränderung umfasst.

Das Anheben der Versorgungsspannung auf eine höhere Spannung kann vorzugsweise durch Verwendung einer Ladepumpe erfolgen. Als Aufladen der Kapazität an einer Elektrode wird vorzugsweise das Einstellen einer Kapazität an der als Kondensator wirkenden Kombination aus Sensorelektrode und Erdungselektrode (Ground) verstanden.

Vorteile und Merkmale, die bezüglich der Dunstabzugshaube beschrieben wurden, gelten soweit anwendbar entsprechend für das erfindungsgemäße Verfahren und umgekehrt.

Zumindest Teile des Verfahrens können mittels eines Mikrocomputers oder Mikrocontrollers durchgeführt werden.

Die Erfindung wird nun mit Bezug auf die beigefügten Figuren genauer beschrieben, wobei

Fig. 1 eine schematische Darstellung von Teilen einer Dunstabzugshaube;

Fig. 2 eine Schaltung zur Steuerung einer Dunstabzugshaube;

Fig. 3 eine Variante der Schaltung von Fig. 2; und

Fig. 4 ein Ablaufdiagramm eines Verfahrens zum Steuern einer Dunstabzugshaube

darstellt.

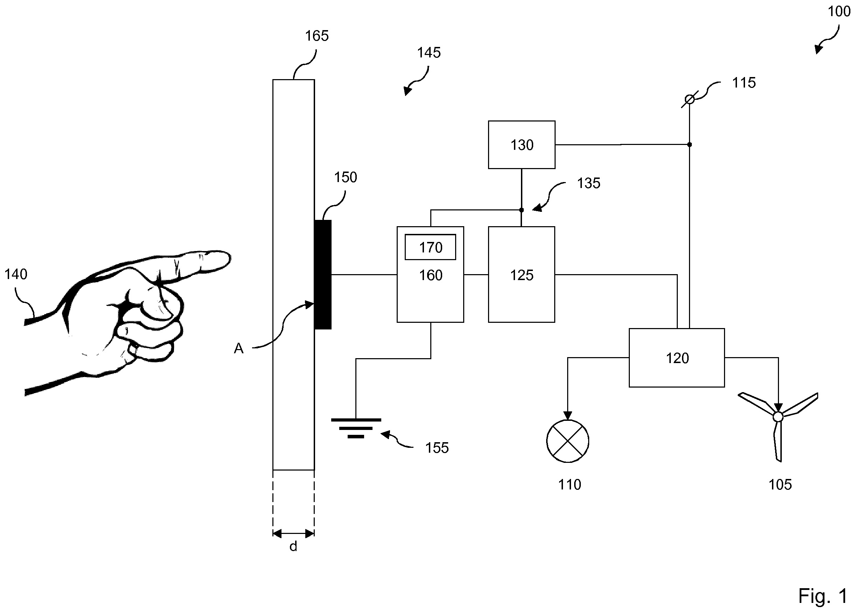

Figur 1 zeigt eine schematische Darstellung von Teilen einer Dunstabzugshaube 100. Die Dunstabzugshaube 100 ist dazu eingerichtet, im Bereich einer Kochstelle angebracht zu werden, um Luft oder Wrasen abzutransportieren. Die Dunstabzugshaube 100 umfasst einen Ventilator 105, der auch als Gebläse bezeichnet wird, und optional eine Beleuchtungseinrichtung 110. Ein Anschluss 115 ist zur Verbindung mit einem Stromnetz vorgesehen. Die Beleuchtungseinrichtung 110 und der Ventilator 105 werden vorzugsweise mit elektrischem Strom betrieben, der vom Anschluss 115 bezogen wird, wobei eine Schalteinrichtung 120 zur Steuerung des Ventilators 105 und der Beleuchtungseinrichtung 110 vorgesehen sein kann.

Die Dunstabzugshaube 100 wird vorzugsweise mittels einer Steuereinrichtung 125 gesteuert. Die Steuereinrichtung 125 kann einen programmierbaren Mikrocomputer oder Mikrocontroller umfassen und wird mit einer elektrischen Spannung betrieben, die vorzugsweise mittels eines Netzteils 130, das mit dem Anschluss 115 verbunden ist, bereitgestellt wird. Eine durch das Netzteil 130 bereitgestellte Versorgungsspannung 135 liegt üblicherweise im Bereich zwischen ca. 5 und ca. 20 V.

Um einen Steuerungswunsch eines Benutzers 140 abzutasten, ist ein kapazitiver Näherungsschalter 145 vorgesehen, der mit der Steuereinrichtung 125 verbunden ist. Der Näherungsschalter 145 umfasst eine Elektrode 150, die auch als Kondensatorelektrode oder Sensorelektrode bezeichnet werden kann und deren Kapazität bezüglich eines Erde-Potentials 155 mittels einer Sensorschaltung 160 bestimmt werden kann. Dazu lädt die Sensorschaltung 160 die Elektrode 150 bezüglich des Erde-Potentials 155 auf der Basis der Versorgungsspannung 135 auf und überwacht die Spannung, die sich an der Elektrode 150 einstellt. Nähert sich der Benutzer 140 mit einem Körperteil an die Elektrode 150 an, so beeinflusst er dadurch deren Kapazität bezüglich des Erde-Potentials 155, sodass sich auch die an der Elektrode 150 anliegende Spannung ändert. Diese Spannungsänderung wird durch die Sensorschaltung 160 abgetastet und ein korrespondierendes Signal wird an die Steuereinrichtung 125 weitergegeben, die daraufhin eine elektrische Funktion der Dunstabzugshaube 100, insbesondere einen Betriebszustand des Ventilators 105 oder der Beleuchtungseinrichtung 110, steuern kann.

Die Elektrode 150 ist üblicherweise elektrisch isoliert von einer Außenseite der Dunstabzugshaube 100. Vorzugsweise umfasst die Dunstabzugshaube 100 eine Abdeckung 165, auf deren Innenseite die Elektrode 150 angebracht ist. Die Abdeckung 165 kann aus einem Glas oder Kunststoff hergestellt sein und bildet vorzugsweise einen Teil eines Gehäuses der Dunstabzugshaube 100, insbesondere der Sichthaube der Dunstabzugshaube 100. Die Abdeckung 165 kann auch als Blende einer Bedieneinheit der Dunstabzugshaube 100 bezeichnet werden.

Die Kapazität an der Elektrode 150 ist abhängig von der Größe A einer Oberfläche der Elektrode 150 und einem Abstand zwischen dem Benutzer 140 und der Elektrode 150. Die Abdeckung 165 weist eine Wandstärke d auf, sodass der Abstand des Benutzers 140 zur Elektrode 150 nicht kleiner als d werden kann. Je größer die Wandstärke d ist, desto geringer ist daher der Unterschied zwischen der Kapazität an der Elektrode 150 in Anwesenheit und in Abwesenheit des Benutzers 140. Es wird vorgeschlagen, die Elektrode 150 auf eine höhere Spannung als die Versorgungsspannung 135 aufzuladen, um eine Spannungsänderung, die durch die Kapazitätsänderung bewirkt sein kann, verbessert detektieren zu können. Insbesondere wird erfindungsgemäß vorgeschlagen, eine Spannungsanhebung 170 vorzusehen, um die Versorgungsspannung 135 auf eine höhere Spannung anzuheben und die Elektrode 150 mittels der angehobenen Spannung aufzuladen.

Figur 2 zeigt eine Schaltung 200 zur Steuerung einer Dunstabzugshaube 100 wie der von Figur 1. Die Schaltung 200 kann insbesondere vom kapazitiven Näherungsschalter 145 in Figur 1 umfasst sein und dort als Spannungsanhebung 170 eingesetzt werden.

Vorzugsweise umfasst die Schaltung 200 einen Oszillator 205, eine Ladungspumpe 210 und eine Auswerteschaltung 215. Der Oszillator 205 kann auf beliebige Weise gebildet werden. In der dargestellten, bevorzugten Ausführungsform ist er als Kippschwinger um ein invertierendes Gatter A1 mit einem Widerstand R1 und einem Kondensator C1 aufgebaut. Das Gatter A1 umfasst vorzugsweise einen Schmitt-Trigger und kann beispielsweise in CMOS-Technik hergestellt sein. Das Gatter A1 wird an der Versorgungsspannung 135 betrieben. An der beispielhaft dargestellten Klemme L1 stellt der Oszillator 205 eine Rechteckspannung bereit, die die Versorgungsspannung 135 nicht übersteigt.

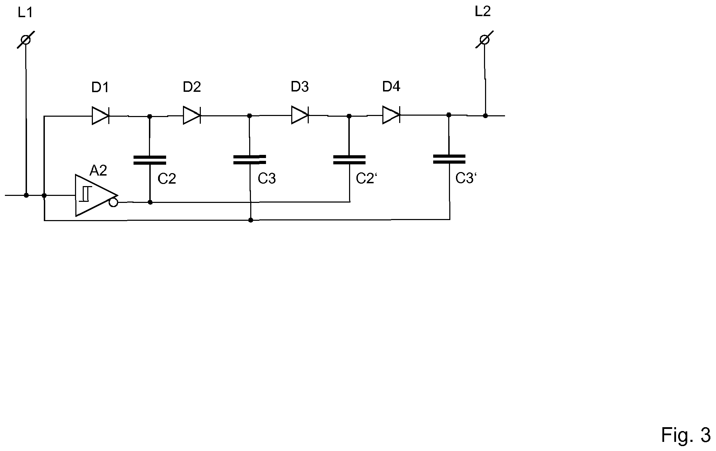

Die Ladungspumpe 210 ist dazu eingerichtet, die Gleichspannung an der Klemme L1 zu vervielfachen. Dazu sind unterschiedliche Grundschaltungen bekannt, von denen eine bevorzugte in Figur 2 dargestellt ist. Die Ladungspumpe 210 ist durch ein invertierendes Gatter A2, Dioden D1 und D2 sowie Kondensatoren C2 und C3 gebildet. Eine Ausgangsspannung der Ladungspumpe 210 liegt an der exemplarisch eingezeichneten Klemme L2 an und beträgt vorzugsweise mehr als 150 % der Eingangsspannung an der Klemme L1. In der dargestellten Ausführungsform beträgt die Ausgangsspannung an der Klemme L2 das Doppelte der Eingangsspannung an der Klemme L1 abzüglich der Summe der Freilaufspannungen der Dioden D1 und D2. Die dargestellte Ladungspumpe 210 umfasst zwei Stufen, sie kann jedoch auch einstufig oder mit mehr als zwei Stufen ausgeführt sein. Dadurch kann die Eingangsspannung, die maximal der Versorgungsspannung 135 entsprechen kann, auch um einen größeren Faktor angehoben werden. Ein Beispiel hierzu wird unten mit Bezug auf Figur 3 genauer beschrieben.

Die Auswerteschaltung 215 umfasst einen Kondensator C5, der in der Darstellung von Figur 1 durch die Elektrode 150 und das Erde-Potential 155 gebildet ist. Der Kondensator C5 wird mittels des Widerstands R2 und des Kondensators C4 auf der Basis der Spannung an der Klemme L2 aufgeladen. Die Spannung zwischen C4 und C5 verändert sich dann, wenn sich die Kapazität des Kondensators C5 ändert, insbesondere wenn sich ein Benutzer 140 der Elektrode 150 annähert oder von ihr entfernt. In diesem Fall steigt oder fällt die Spannung am Kondensator C5 vorübergehend an oder fällt ab.

Eine Möglichkeit, eine derartige Änderung auszuwerten, wird mit der dargestellten Auswerteschaltung 215 mit einem Transistor T1, Widerständen R3 bis R6 und Kondensatoren C6 und C7 realisiert. Vergrößert sich die Kapazität des Kondensators C5 durch Annähern des Benutzers 140 an die Elektrode 150, so sinkt die Spannung an der Basis des Transistors T1 ab, sodass der Transistor T1 leitet und den Widerstand R6 an die Spannung an der Klemme L2 legt. An der beispielhaft dargestellten Klemme L3 zeigt sich dies durch einen raschen Anstieg der an C6, C7 und L3 anliegenden Spannungen. Der Kondensator C5 wird über den Widerstand R2 und den Kondensator C4 nachgeladen, sodass seine Spannung wieder ansteigt bis der Transistor T1 sperrt. Dann entspricht die Spannung an der Klemme L3 wegen des Widerstands R5 im Wesentlichen wieder dem Massepotential 155. Anders ausgedrückt kann an L3 ein positiver Impuls beobachtet werden, wenn der Benutzer 140 in den Bereich der Elektrode 150 gelangt.

Die Spannungsänderung am Kondensator C5 kann in einer anderen Ausführungsform auch mittels eines Mikrocontrollers bestimmt werden, der in regelmäßigen Abständen die Spannung am Kondensator C5 digitalisiert und Änderungen numerisch bestimmt. Der Mikrocontroller kann beispielsweise von der Steuereinrichtung 125 in Figur 1 umfasst sein. Dadurch können mehrere diskrete Bauelemente der Auswerteschaltung 215 eingespart werden.

Der Mikrocontroller kann auch dazu verwendet werden, den Oszillator 205 zu bilden. Dazu kann der Mikrocontroller dazu programmiert werden, eine Rechteckspannung bereitzustellen, die an den Eingang der Ladungspumpe 210 an der Klemme L1 geleitet wird. Der dargestellte Kippschwinger um das invertierende Gatter A1 kann dabei entfallen. In noch einer weiteren Ausführungsform kann der Oszillator 205 auch auf eine andere Weise realisiert sein, beispielsweise mittels eines Quarzes, eines keramischen Resonators oder eines rückgekoppelten Flipflops.

Figur 3 zeigt eine Variante der Ladungspumpe 210 von Figur 2. Die hier dargestellte Variante umfasst eine dritte Stufe mit einer Diode D3 und einem Kondensator C2' und eine optionale vierte Stufe mit einer Diode D4 und einem Kondensator C3'. Die vierstufige Ladungspumpe 210 kann eine Vervierfachung der Eingangsspannung an der Klemme L1, vermindert um die Summe der Freilaufspannungen der Dioden D1 bis D4, realisieren. In entsprechender Weise kann die dreistufige Ladungspumpe 210 ohne die Diode D4 und den Kondensator C3' annähernd eine Verdreifachung - vermindert um die Summe der Freilaufspannungen der Dioden D1 bis D3 - der Eingangsspannung an der Klemme L1 realisieren.

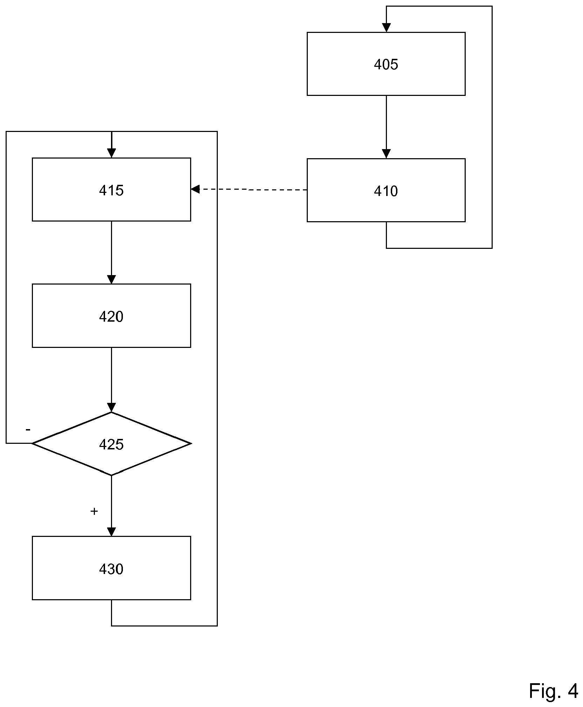

Figur 4 zeigt ein Ablaufdiagramm einer Ausführungsform des erfindungsgemäßen Verfahrens 400 zum Steuern einer Dunstabzugshaube 100 wie der von Figur 1. Das Verfahren 400 kann wenigstens in Teilen auf der Verarbeitungseinrichtung 125 ausgeführt werden.

In einem Schritt 405 wird die Versorgungsspannung 135 angehoben, wie oben bezüglich der Ladungspumpe 210 ausführlich beschrieben ist. Mittels der angehobenen Spannung wird dann in einem Schritt 410 ein Kondensator C5 aufgeladen, der vorzugsweise durch eine Elektrode 150 bezüglich eines Erde-Potentials 155 gebildet ist, wie oben mit Bezug auf Figur 1 näher erläutert ist. Die Schritte 405 und 410 können nebenläufig zu weiteren Schritten des Verfahrens 400 ablaufen.

In einem Schritt 415 wird eine Spannung an dem Kondensator C5 bzw. der Kapazität an der Elektrode 150 bestimmt. Anschließend wird die bestimmte Spannung in einem Schritt 420 mit einem zuvor bestimmten Wert verglichen. In einem Schritt 425 wird dann entschieden, ob sich die Spannung um mehr als einen vorbestimmten Schwellenwert geändert hat oder ob die Änderungsgeschwindigkeit einen anderen vorbestimmten Schwellenwert übersteigt. Ist dies nicht der Fall, so kann dieser Teil des Verfahrens 400 zum Schritt 415 zurückkehren. Andernfalls wird in einem Schritt 430, vorzugsweise mittels der Verarbeitungseinrichtung 125, eine der Elektrode 150 zugeordnete Funktion der Dunstabzugshaube 100 gesteuert. Diese Funktion kann insbesondere das Einstellen einer vorbestimmten Drehzahl des Ventilators 105 oder einer vorbestimmten Leuchtstärke der Beleuchtungseinrichtung 110 umfassen. Anschließend kehrt dieser Teil des Verfahrens 400 vorzugsweise zum Schritt 415 zurück.

Die Erfindung kann auch auf die folgende Weise ausgedrückt werden.

Zweck der Erfindung ist, eine Schaltung 200 zur kapazitiven Messung zu optimieren, so dass Schaltsignale durch Medien 165, wie beispielsweise Glas- oder Kunststoffscheiben, die dicker als beispielsweise 4 mm sind, besser detektierbar sind. Die kapazitive Messung wird an einer Dunstabzugshaube 100 zur Detektion eines Schalterereignisses in einem Bedienteil eingesetzt. Das Schalterereignis kann ein Annähern oder ein Entfernen eines Benutzers 140 aus einem Bereich einer Sensorelektrode 150 umfassen.

In Dunstabzugshauben 100 mit Glas- oder Kunststofffront (Blende, Halter, Abdeckung 165) werden meist kapazitive Touchbedienteile 145 eingesetzt. Hinter jedem Schalter befindet sich eine Elektrode 150 für eine Kapazitätsmessung. Durch die Annäherung beispielsweise eines Fingers des Benutzers an die Touchfläche im Bereich der Elektrode 150 wird die relative Permittivität $\varepsilon_r$ des Kondensators C5 verändert, der die Elektrode 150 umfasst. Das heißt, es erfolgt eine Änderung der Kapazität C des Kondensators C5.

Die Kapazität C des Kondensators C5, der durch die Elektrode 150 und das Erde-Potential 155 gebildet ist, bestimmt sich wie folgt: $C = \varepsilon_0 \cdot \varepsilon_r \cdot \frac{A}{d}$, wobei $\varepsilon_0 \approx 8{,}85 \cdot 10^{-12} \frac{As}{Vm}$ die elektrische Feldkonstante im Vakuum ist.

Beispiele für $\varepsilon_r$:

$\varepsilon_r$ Luft: ca. 1
$\varepsilon_r$ Wasser (menschlicher Finger): ca. 80.

Wird also ein Objekt wie ein Finger des Benutzers 140 in den Bereich des Kondensators C5 gebracht, so verändert sich dessen Kapazität C.

Bisher bekannte Schaltungen 200 arbeiten nur bis zu einer begrenzten Materialdicke d zwischen Kondensatorelektrode 150 und Finger 140. Des Weiteren steht meist nur eine geringe Spannung 135 zur Detektion der Kapazität zur Verfügung. Durch eine vorgeschlagene Schaltung zur Spannungsanhebung 170 wird die Spannung am Kondensator C5 zur Detektion erhöht und ermöglicht somit den Einsatz von dicken Medien 165, durch die ein Schaltsignal detektiert werden kann.

Die Erfindung beinhaltet vorzugsweise für eine Spannungsanhebung 170 einen Oszillator 205 mit einer Ladungspumpe 210 zu kombinieren. Hierdurch entsteht wegen des Einsatzes von nur wenigen Bauteilen eine kostengünstige Spannungsanhebung 170. Durch die Spannungsanhebung 170 kann auch durch dicke Materialien 165 eine Kapazitätsänderung detektiert werden. Durch die Anzahl an Kaskaden (Stufen) kann die Spannungshöhe beliebig angepasst werden.

In einem Beispiel wird ein Oszillator 205 als Kippschwinger mit invertierendem Schmitt-Trigger ausgeführt. Die Ladungspumpe 210 enthält zwei Stufen. Sie kann wahlweise auch mit einer oder mehr als zwei Stufen ausgestattet werden.

Die Kapazitätsmessung kann mit einem PNP Transistor T1 aufgebaut sein. Durch die Kapazitätserhöhung C5 wird der Strom an der Basis verändert und das Signal an der Klemme L3 ändert sich.

Die vorliegende Erfindung weist eine Reihe von Vorteilen auf. Durch die Schaltung 200 ist die Signaländerung an C5 bei Annäherung oder Entfernung des Fingers des Benutzers 140 wesentlich größer und somit leichter zu detektieren. Durch die Schaltung 200 können Schaltsignale auch durch dickere Medien, wie beispielsweise Glas oder Kunststoffscheiben 165 von mehr als 4 mm detektiert werden. Vorteile bietet die Schaltung 200 besonders in solchen Bereichen, in denen nur eine geringe Versorgungsspannung 135 zur Verfügung steht. Die Schaltung 200 kann mit ihren wenigen Komponenten kostengünstig und platzsparend aufgebaut werden. Die Schaltung 200 kann in jedem kapazitiven Touchbedienteil 145 eingesetzt werden.

Bezugszeichen

100 Dunstabzugshaube
105 Ventilator
110 Beleuchtungseinrichtung
115 Anschluss
120 Schalteinrichtung
125 Steuereinrichtung
130 Netzteil
135 Versorgungsspannung
140 Benutzer
145 kapazitiver Näherungsschalter
150 Elektrode
155 Erde-Potential (GND)
160 Sensorschaltung
165 Abdeckung
170 Spannungsanhebung

d Wandstärke
A Oberfläche

200 Schaltung
205 Oszillator
210 Ladungspumpe
215 Auswerteschaltung

L1-L3 Klemmen
A1, A2 invertierende Gatter
R1-6 Widerstände
C1-7 Kondensatoren
T1 Transistor
D1-D4 Dioden

400 Verfahren
405 Anheben Versorgungsspannung
410 Aufladen Kapazität
415 Bestimmen Spannung an Kapazität
420 Vergleichen mit früher bestimmtem Wert
425 Unterschied oder Änderungsgeschwindigkeit > Schwellenwert?
430 Steuern Funktion

**Patentansprüche**

1. Dunstabzugshaube (100) mit einem kapazitiven Näherungsschalter (145) zur Steuerung einer elektrischen Funktion der Dunstabzugshaube (100),

- der dazu eingerichtet ist, eine Änderung einer elektrischen Kapazität an einer Elektrode (150) zu bestimmen,
- die mittels einer nichtleitenden Abdeckung (165) gegenüber einem Benutzer (140) abgedeckt ist; **dadurch gekennzeichnet, dass**
- eine Spannungsanhebung (210) vorgesehen ist, um die Elektrode (150) auf eine höhere Spannung als eine Versorgungsspannung (135) des kapazitiven Näherungsschalters (145) aufzuladen, wobei die Spannungsanhebung (170) eine Ladungspumpe (210) umfasst, wobei die Dunstabzugshaube (100) einen als Kippschwinger ausgeführten Oszillator (205) zur Bereitstellung einer Wechselspannung für die Spannungsanhebung (210) umfasst und der Kippschwinger (205) ein erstes invertierendes Gatter (A1) und die Ladungspumpe (210) ein zweites invertierendes Gatter (A2) umfasst und beide Gatter (A1, A2) in einem gemeinsamen elektronischen Bauteil integriert sind.

**2.** Dunstabzugshaube (100) nach Anspruch 1, wobei die Ladungspumpe (210) mehrere kaskadierte Stufen (D1, C2; D2, C3; D3, C2'; D4, C3') aufweist.

**3.** Dunstabzugshaube (100) nach einem der vorangehenden Ansprüche, wobei die Versorgungsspannung (135) um wenigstens 150 % angehoben wird.

**4.** Dunstabzugshaube (100) nach einem der vorangehenden Ansprüche, ferner umfassend einen Mikrocontroller (125), der dazu eingerichtet ist, die elektrische Funktion der Dunstabzugshaube (100) zu steuern, wobei der Mikrocontroller (125) ferner dazu eingerichtet ist, eine Spannung an der Elektrode (150) zu bestimmen und mit einer zuvor bestimmten Spannung zu vergleichen.

**5.** Verfahren (400) zur Steuerung einer Dunstabzugshaube (100), (100) nach einem der vorhergehenden Ansprüche, wobei das Verfahren (400) folgende Schritte aufweist:

- Anheben (405) einer Versorgungsspannung (135) auf eine höhere Spannung;
- Aufladen (410) einer Kapazität einer Elektrode (150) mittels der angehobenen Spannung;
- Bestimmen (420, 425) einer durch einen Benutzer (140) der Dunstabzugshaube bewirkten Veränderung der Kapazität; und
- Steuern (430) einer elektrischen Funktion der Dunstabzugshaube (100) in Abhängigkeit der bestimmten Veränderung.

## Claims

**1.** Extractor hood (100) with a capacitive proximity switch (145) for controlling an electrical function of the extractor hood (100),

- said capacitive proximity switch being configured to determine a change in an electrical capacitance at an electrode (150),
- which is shielded in respect of a user (140) by means of a non-conductive shield (165),

**characterised in that**

- a voltage boost facility (210) is provided in order to charge up the electrode (150) to a higher voltage than a supply voltage (135) of the capacitive proximity switch (145), wherein the voltage boost facility (170) comprises a charge pump (210),

wherein
the extractor hood (100) comprises an oscillator (205) embodied as a relaxation oscillator for providing an AC voltage for the voltage boost facility (210) and the relaxation oscillator (205) comprises a first inverting gate (A1) and the charge pump (210) comprises a second inverting gate (A2) and both gates (A1, A2) are integrated into a common electronic component.

**2.** Extractor hood (100) according to claim 1, wherein the charge pump (210) has multiple cascaded stages (D1, C2; D2, C3; D3, C2'; D4, C3').

**3.** Extractor hood (100) according to one of the preceding claims, wherein the supply voltage (135) is boosted by at least 150 %.

**4.** Extractor hood (100) according to one of the preceding claims, further comprising a microcontroller (125) configured to control the electrical function of the extractor hood (100), wherein the microcontroller (125) is configured further to determine a voltage at the electrode (150) and to compare it with a previously determined voltage.

**5.** Method (400) for controlling an extractor hood (100), (100) according to one of the preceding claims, wherein the method (400) has the following steps:

- Boosting (405) a supply voltage (135) to a higher voltage,
- Charging up (410) a capacitance of an electrode (150) by means of the boosted voltage,
- Determining (420, 425) a change in capacitance effected by a user (140) of the extractor hood, and
- Controlling (430) an electrical function of the extractor hood (100) as a function of the determined change.

## Revendications

**1.** Hotte aspirante (100) comprenant un détecteur capacitif de proximité (145) destiné à la commande d'une fonction électrique de la hotte aspirante (100),

- servant à déterminer la variation d'une capacité électrique sur une électrode (150),
- recouverte d'un recouvrement (165) non conducteur pour un utilisateur (140);

**caractérisée en ce que**

- une augmentation de la tension (210) est prévue pour charger l'électrode (150) à une tension supérieure à la tension d'alimentation (135) du détecteur capacitif de proximité (145), l'augmentation de tension (170) comprenant une pompe de charge (210), la hotte aspirante (100) comprenant un oscillateur (205) réalisé en tant qu'oscillateur à relaxation pour fournir une tension alternative destinée à augmenter la tension (210) et l'oscillateur à relaxation (205) comprenant une première grille à inversion (A1) et la pompe de charge (210) comprenant une deuxième grille à inversion (A2), et les deux grilles (A1, A2) étant intégrées dans un même module électronique.

**2.** Hotte aspirante (100) selon la revendication 1, dans laquelle la pompe de charge (210) comprend plusieurs étages en cascade (D1, C2; D2, C3; D3, C2'; D4, C3').

**3.** Hotte aspirante (100) selon l'une des revendications précédentes, dans laquelle la tension d'alimentation (135) est augmentée d'au moins 150 %.

**4.** Hotte aspirante (100) selon l'une des revendications précédentes, comprenant en outre un microcontrôleur (125) servant à commander la fonction électrique de la hotte aspirante (100), le microcontrôleur (125) servant en outre à déterminer une tension sur l'électrode (150) et à la comparer avec une tension déterminée précédemment.

**5.** Procédé (400) de commande d'une hotte aspirante (100) selon l'une des revendications précédentes, dans lequel le procédé (400) comprend les étapes suivantes:

- augmentation (405) de la tension d'alimentation (135) à une tension supérieure;
- charge (410) de la capacité d'une électrode (150) au moyen de la tension augmentée;
- détermination (420, 425) de la variation de la capacité causée par l'utilisateur (140) de la hotte aspirante; et
- commande (430) d'une fonction électrique de la hotte aspirante (100) dépendant de la variation déterminée.

100
115
105
120
110
135
130
125
145
170
160
155
150
165
A
d
140

Fig. 1

200
L3
GND
C7
R6
C6
T1
R5
R4
R3
C5
C4
R2
L2
C3
D2
C2
D1
A2
L1
R1
A1
C1
215
210
205
Fig. 2

Fig. 3

L2
C3'
D4
C2'
D3
C3
D2
C2
D1
A2
L1

405
410
415
420
425
-
+
430

Fig. 4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 2261568 A1
- US 20130241630 A1
- EP 2224174 A2